# FASCICULE DE BREVET EUROPEEN

(11) **EP 2 498 279 B1**
(45) Date de publication et mention de la délivrance du brevet: **01.10.2014**
(21) Numéro de dépôt: 12157408.1
(22) Date de dépôt: 29.02.2012
(51) Int. Cl.: C23C 14/06, C23C 14/58, H01L 21/28, H01L 33/40, H01L 21/768, H01L 29/45

(54) **Procédé de traitement d'une couche oxydée de nitrure d'un métal de transition**
Behandlungsverfahren einer oxidierten Übergangsmetall-Nitrid-Schicht
Treatment process of an oxidized transition metal nitride layer

(30) Priorité: 07.03.2011 FR 1151850
(43) Date de publication de la demande: 12.09.2012
(73) Titulaire: Altis Semiconductor, 91105 Corbeil Essonnes Cedex (FR)
(72) Inventeur: Aube, Michel, 77310 PONTHIERRY (FR); De Person, Pierre, 94230 Cachan (FR)
(74) Mandataire: Peguet, Wilfried

(56) Documents cités:
- EP-A1- 0 776 991
- EP-A2- 1 001 454
- EP-A2- 1 126 046
- JP-A- 11 330 546
- US-A- 5 970 378
- US-A1- 2003 155 575
- US-A1- 2007 141 806
- US-B1- 6 211 072

## Description

La présente invention se rapporte à un procédé de traitement d'une couche oxydée de nitrure d'un métal de transition.

Elle s'applique typiquement, mais non exclusivement, à la fabrication d'électrodes métalliques, utilisées notamment dans la fabrication de diodes électroluminescentes.

Du document US 2003/155575 est connu l'emploi du nitrure de titane (TiN) ou du nitrure de tantale (TaN) comme électrode déposée par pulvérisation cathodique suivie d'un recuit à 800°C de la diode électroluminescente.

Du document US 6 211 072 est connu un procédé de traitement d'une couche de nitrure de titane contaminée par du carbone et de l'oxygène consistant à exposer la couche contaminée à un plasma d'hydrogène et d'azote afin d'en éliminer les contaminants.

Du document US 6 169 027 est connu un procédé de traitement consistant à éliminer la présence d'une couche d'oxyde de titane formée à la surface d'une couche de nitrure de titane, en appliquant un plasma d'hydrogène et d'azote à une température élevée. Ainsi, l'oxyde de titane est réduit par l'hydrogène pour former du nitrure de titane. Toutefois, l'inconvénient de ce type de procédé est qu'il doit être réalisé à température élevée, c'est-à-dire à une température comprise entre 400 et 550 °C. En effet, une température aussi élevée, nécessitée par le fait de réduire directement le nitrure de titane, ne permet pas de réaliser le procédé de l'art antérieur sur un assemblage d'éléments comprenant la couche de nitrure de titane, et d'autres couches et/ou composants (e.g. transistors, résistances, etc) dont les propriétés physico-chimiques se dégradent à température élevée, notamment à des températures supérieures à 400 °C.

Le but de la présente invention est de pallier les inconvénients des techniques de l'art antérieur en proposant notamment un procédé de traitement à basse température, d'une couche oxydée de nitrure d'un métal de transition, permettant de supprimer au moins en partie, voire en totalité, la couche d'oxyde dudit métal formée à la surface de la couche de nitrure de ce métal, tout en garantissant une surface sensiblement uniforme de la couche de nitrure de métal une fois la couche d'oxyde dudit métal supprimée.

La présente invention a pour objet un procédé de traitement d'une couche de nitrure de métal oxydée, comprenant les étapes consistant à :
i. oxyder une couche d'oxyde de métal à la surface d'une première couche de nitrure dudit métal, à l'aide d'un plasma d'une espèce oxydante à base de fluor, pour former une couche métallique composée de fluorure dudit métal, le métal de la couche de nitrure de métal, de la couche d'oxyde de métal, et de la couche métallique étant un métal appartenant à la famille des métaux de transition, et
ii. réduire la couche métallique formée à l'étape i à l'aide d'un plasma d'hydrogène et d'azote, pour former une deuxième couche de nitrure dudit métal.

Grâce à la présente invention, ladite couche d'oxyde du métal de transition est éliminée en étant remplacée chimiquement (cf. oxydation) par ladite couche métallique à l'étape i, cette couche métallique étant ensuite transformée chimiquement (cf. réduction) à l'étape ii en une couche de nitrure dudit métal, le procédé de traitement selon l'invention étant réalisé à basse température.

Le fait de pouvoir éliminer ladite couche d'oxyde du métal de transition permet également de supprimer tous les contaminants ou polluants susceptibles de se trouver à la surface de ladite couche d'oxyde de ce métal, notamment les contaminants susceptibles de provenir des étapes de gravure préalables, tels que par exemple des polymères comprenant des atomes de carbone, d'oxygène, de fluor, etc.

En outre, la couche d'oxyde du métal de transition une fois supprimée, permet avantageusement d'obtenir une deuxième couche de nitrure dudit métal d'épaisseur sensiblement uniforme à la surface de la première couche de nitrure de ce métal.

Cette uniformité d'épaisseur, ou en d'autres termes cette planéité, est très avantageuse notamment dans le cas de l'utilisation de la couche de nitrure d'un métal de transition ainsi traitée lors de la fabrication de diodes électroluminescentes. En effet, cette planéité permet de garantir de bonnes propriétés de résistivité électrique, qui se traduisent notamment par un signal lumineux émis uniforme dans le domaine des diodes électroluminescentes.

Dans la présente invention, au moins la couche de nitrure du métal de transition recouverte par la couche d'oxyde dudit métal (i.e. couche de nitrure de métal oxydée) forment un empilement de couches. Ledit empilement de couches formée par la première et la deuxième couches de nitrure dudit métal reste stable à l'atmosphère ambiante.

L'empilement de couches, tel que la couche de nitrure du métal oxydée, peut faire partie d'un assemblage d'éléments comprenant une tranche d'un substrat semi-conducteur qui est la couche initiale sur laquelle est déposée l'ensemble des couches constitutives de l'assemblage. Entre la tranche dudit substrat et la couche de nitrure de métal oxydée peuvent se trouver d'autres couches et/ou composants.

Les couches de l'invention sont de préférence des couches minces de section transversale circulaire. L'épaisseur de ces couches peut aller de quelques dixièmes de nanomètre (angströms) à quelques centaines de nanomètres (millier d'angströms).

L'élimination totale de la couche d'oxyde de métal formée à la surface de la première couche de nitrure dudit métal peut s'effectuer en consommant une partie de la première couche de nitrure de ce métal lors de l'étape ii. Bien entendu, l'homme du métier pourra jouer sur les conditions opératoires de l'étape ii pour minimiser ladite consommation.

La couche d'oxyde dudit métal se forme classiquement suite à certains procédés de délaquage (connu sous l'anglicisme de « *stripping* ») nécessitant un plasma à base d'oxygène. Par exemple, on peut citer le délaquage par plasma d'oxygène (O₂) d'un masque de résine ayant été déposé sur la première couche de nitrure dudit métal, lors de la fabrication d'une électrode métallique.

On entend par « électrode métallique » un empilement de plusieurs couches électriquement conductrices comprenant au moins une couche électriquement conductrice, telle que par exemple une couche d'aluminium, ou de cuivre, ou une couche d'un mélange d'aluminium et de cuivre, sur laquelle a été déposée la première couche de nitrure dudit métal.

Par conséquent, la formation d'une couche d'oxyde de métal à la surface de la première couche de nitrure dudit métal est néfaste à l'électrode puisque cette couche d'oxyde de métal fait office de barrière électrique du fait de sa résistivité électrique, par rapport à ladite couche de nitrure de ce métal.

Dans ce cas, la première couche de nitrure dudit métal, déposée sur la couche électriquement conductrice, peut être définie comme une couche dite d'encapsulation, électriquement conductrice, et protégeant la couche électriquement conductrice des interactions physico-chimiques pouvant se produire lors des étapes suivant le dépôt de la couche électriquement conductrice.

Le procédé de traitement selon l'invention a l'avantage de pouvoir être effectué à basse température afin d'éviter toute dégradation des composants (e.g. transistors, résistances, etc) constitutifs d'un assemblage d'éléments comprenant la couche de nitrure de titane oxydée à traiter, lesdits composants pouvant avoir des propriétés physico-chimiques se dégradant à des températures supérieures à ladite « basse température ». En d'autres termes, les températures des étapes i et ii sont notamment inférieures aux températures de dégradation des propriétés physico-chimiques desdits composants.

Plus particulièrement, ledit procédé peut être effectué à des températures strictement inférieures à 400 °C, voire à des températures beaucoup plus faibles. Ainsi, les étapes i et ii du procédé de traitement selon l'invention peuvent être réalisées à des températures strictement inférieures à 400 °C.

Dans un premier mode de réalisation particulièrement avantageux, l'étape i s'effectue à une température d'au plus 300 °C, de préférence d'au plus 200 °C, et plus préférentiellement d'au plus 100 °C.

Dans un deuxième mode de réalisation particulièrement avantageux, l'étape ii s'effectue à une température d'au plus 300 °C, de préférence d'au plus 200 °C, et plus préférentiellement d'au plus 100 °C.

Dans un troisième mode de réalisation, le premier et le deuxième modes sont combinés.

Les étapes i et ii selon l'invention sont de préférence réalisées au sein d'un réacteur plasma comportant un porte-échantillon. Les températures mentionnées dans la présente invention sont celles mesurées au sein du réacteur plasma dans lequel sont réalisées les étapes i et ii, et plus particulièrement ces températures sont celles du porte-échantillon sur lequel est positionné l'empilement à traiter comprenant la première couche de nitrure d'un métal de transition oxydée.

En outre, les étapes i et ii sont de préférence réalisées en atmosphère inerte, ou en d'autres termes en atmosphère exempte d'oxygène. Par exemple, elles peuvent être réalisées sous atmosphère d'azote ou sous vide.

Le métal constitutif de la couche du nitrure de métal, de la couche d'oxyde de métal, et de la couche métallique est le même métal appartenant à la famille des métaux de transition, et peut être choisi avantageusement parmi le tantale, le titane et le tungstène, ou un de leurs mélanges.

L'espèce oxydante conforme à l'invention est un plasma à base de fluor (i.e. un plasma comprenant du fluor). On peut citer notamment le trifluorure d'azote (NF₃).

Le plasma étant à base de fluor, la couche métallique est une couche composée de fluorure de métal de transition.

Lorsque le métal de transition considéré est le tantale ou le titane, ledit fluorure de métal est ainsi le fluorure de tantale ou le fluorure de titane.

Dans l'étape ii, le plasma d'hydrogène et d'azote peut être quant à lui choisi parmi un plasma d'un mélange d'hydrogène et d'azote ; et un plasma de NH₃; ou leur mélange.

Dans la présente invention, la densité électronique, l'énergie de bombardement et la durée des plasmas des étapes i et ii sont des paramètres bien connus de l'homme du métier pour optimiser la transformation chimique de la couche d'oxyde de métal en couche métallique (étape i), et la transformation chimique de la couche métallique en couche de nitrure de métal (étape ii).

Ces paramètres sont réglés afin de pouvoir former un plasma stable pendant une durée suffisante pour permettre de remplacer la couche d'oxyde du métal de transition par la couche métallique dans l'étape i, et pour permettre de transformer cette couche métallique en une couche de nitrure dudit métal dans l'étape ii.

A titre d'exemple, pour les étapes i et ii, on peut citer une densité électronique autour de 1,2.10¹⁰ cm⁻³, une énergie de bombardement comprise entre 120 et 210 eV, et une durée de l'ordre de 15 à 20 s.

Un exemple d'application du procédé selon l'invention concerne un empilement de couches comprenant ladite première couche de nitrure de métal de transition recouverte par ladite deuxième couche de nitrure dudit métal, lesdites couches étant obtenues par le procédé de traitement selon la présente invention.

Cet empilement de deux couches de nitrure du même métal présente l'avantage de garantir de bonnes propriétés de résistivité électrique, qui se traduisent notamment par un signal lumineux émis uniforme dans le domaine des diodes électroluminescentes.

Un autre exemple d'application du procédé selon l'invention concerne une électrode métallique comprenant ladite première couche de nitrure de métal de transition recouverte par ladite deuxième couche de nitrure dudit métal, lesdites couches étant obtenues par le procédé de traitement selon la présente invention.

Cette électrode métallique peut être une anode, notamment utilisée dans la fabrication de diodes électroluminescentes, cette anode permettant la transmission de la lumière vers les filtres de coloration dans ce type de technologie.

Un autre objet selon l'invention concerne une diode électroluminescente comprenant ladite première couche de nitrure de métal de transition recouverte par ladite deuxième couche de nitrure dudit métal, lesdites couches étant obtenues par le procédé de traitement selon la présente invention.

D'autres caractéristiques et avantages de la présente invention apparaîtront à la lumière d'un exemple qui va suivre en référence aux figures annotées, l'exemple et les figures étant donnés à titre illustratif et nullement limitatif.
La figure 1 représente une vue de face d'un empilement de deux couches, avant l'application du procédé de traitement selon l'invention.
La figure 2 représente l'empilement de la figure 1 une fois l'étape i de l'invention effectuée.
La figure 3 représente l'empilement de la figure 2 une fois l'étape ii de l'invention effectuée.

Pour des raisons de clarté, les mêmes éléments ont été désignés par des références identiques. En outre, seuls les éléments essentiels pour la compréhension de l'invention ont été représentés de manière schématique, et ceci sans respect de l'échelle.

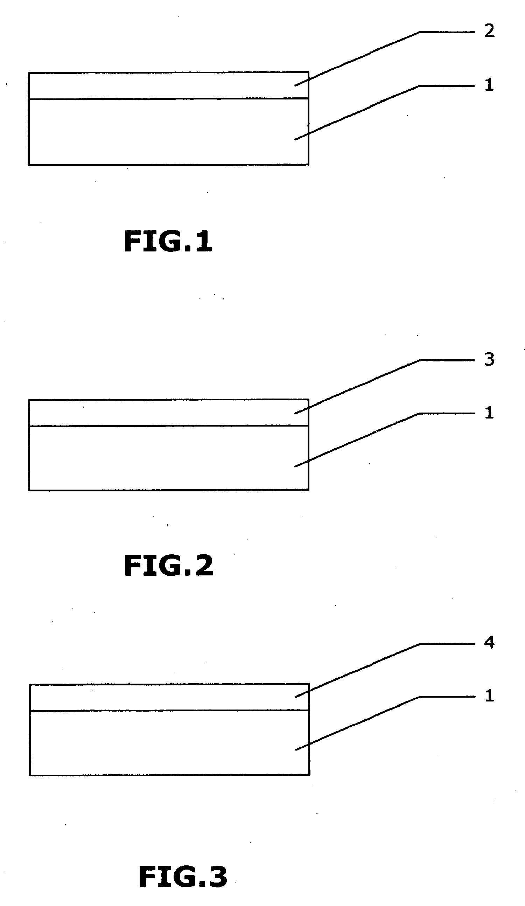

La figure 1 représente un empilement d'au moins deux couches de section transversale circulaire de diamètre de 200 mm, avant l'application du procédé de traitement selon la présente invention. Ces deux couches sont une première couche de nitrure de titane (1), d'une épaisseur de 8 nm (80 angströms), dont la partie supérieure est recouverte par une couche d'oxyde de titane (2), d'une épaisseur d'environ 4 nm (40 angströms). L'épaisseur totale de ces deux couches est donc de 12 nm (120 angströms).

Ledit empilement est déposé sur le porte-échantillon d'un réacteur plasma commercialisé par la société Tokyo Electron Limited, sous la référence 85 SCCM. Bien entendu, la première couche de nitrure n'est pas directement en contact physique avec le porte-échantillon. Ledit empilement est à l'origine déposé sur une tranche d'un substrat d'un matériau semi-conducteur (non représenté sur les figures 1 à 3) tel que du silicium. Ledit empilement est donc déposé sur le porte-échantillon par l'intermédiaire dudit substrat.

Dans un premier temps et au sein de ce réacteur et sous atmosphère d'azote, la couche d'oxyde de titane (2) est oxydée par un plasma de trifluorure d'azote (NF₃), pour former du fluorure de titane et de l'oxyde d'azote.

Les conditions de la réaction d'oxydation sont les suivantes :
- densité électronique du plasma : 1,2.10¹⁰ cm⁻³,
- énergie de bombardement du plasma : 200 eV,
- température du porte-échantillon : 50 °C, et
- durée de l'étape d'oxydation : 15 s.

Une fois l'étape d'oxydation réalisée, on obtient l'empilement de la figure 2 comprenant toujours la première couche de nitrure de titane (1) recouverte, non plus par la couche d'oxyde de titane (2), mais par une couche métallique de fluorure de titane (3) de section transversale circulaire.

Dans un second temps et au sein du même réacteur, toujours sous atmosphère d'azote, la couche de fluorure de titane (3) est réduite par un plasma comprenant un mélange d'hydrogène (H₂) et d'azote (N₂), pour former du nitrure de titane et de l'acide fluorhydrique.

Les conditions de la réaction de réduction sont les suivantes :
- densité électronique du plasma : 1,2.10¹⁰ cm⁻³,
- énergie de bombardement du plasma : 140 eV,
- température du porte-échantillon : 50 °C, et
- durée de l'étape de réduction : 20 s.

Une fois l'étape de réduction réalisée, on obtient l'empilement de la figure 3 comprenant toujours la première couche de nitrure de titane (1) recouverte, non plus par la couche de fluorure de titane (3), mais par une deuxième couche de nitrure de titane (4) de section transversale circulaire.

L'étape de réduction a bien entendu consommé un peu de nitrure de titane de la première couche de nitrure de titane, l'épaisseur totale de l'empilement formé par la première et la deuxième couche de nitrure de titane étant après l'étape ii de 6,7 nm (67 angströms).

Toutefois, cette consommation du nitrure de titane suite à l'étape de réduction peut être minimisée facilement par l'homme du métier en jouant sur les conditions opératoires de la réduction (densité de puissance en radiofréquence (RF) du plasma et/ou température du porte-échantillon et/ou durée de l'étape de réduction).

Les mesures d'épaisseurs des couches dans le cadre de la présente invention ont été réalisées par fluorescence X à l'aide d'un appareil de marque Panalytical.

Afin de vérifier l'uniformité de la deuxième couche de nitrure de titane, la variation d'épaisseur sur toute la surface de ladite couche a également été mesurée par fluorescence X à l'aide du même appareil que mentionné ci-avant.

Ces mesures ont été effectuées en cinq points différents de la deuxième couche de nitrure de titane : une mesure au centre et quatre mesures en périphérie à 4 cm du bord externe de ladite couche, à 90° (degrés) les unes des autres.

La variation entre la plus petite épaisseur mesurée et la plus grande épaisseur mesurée sur l'épaisseur totale de l'empilement formée par la première et la deuxième couche de nitrure de titane est de seulement 1,4 nm (14 angströms), ou en d'autres termes l'épaisseur totale est de 6,7 nm (67 angströms) plus ou moins 0,7 nm (7 angströms).

Par ailleurs, les empilements représentés sur les figures 1 à 3 ne sont pas limités à ces deux couches. En effet, dans le cas de la fabrication d'une électrode métallique, la première couche de nitrure de métal est typiquement déposée sur une couche électriquement conductrice telle qu'une couche d'aluminium et/ou de cuivre (non représentée sur les figures 1 à 3).

## Revendications

1. Procédé de traitement d'une couche de nitrure de métal oxydée, comprenant les étapes consistant à :
i. oxyder une couche (2) d'oxyde de métal à la surface d'une première couche (1) de nitrure dudit métal, à l'aide d'un plasma d'une espèce oxydante à base de fluor, pour former une couche (3) métallique composée de fluorure dudit métal, le métal de la couche (1) de nitrure de métal, de la couche (2) d'oxyde de métal, et de la couche (3) métallique étant un métal appartenant à la famille des métaux de transition, et
ii. réduire la couche (3) métallique formée à l'étape i à l'aide d'un plasma d'hydrogène et d'azote, pour former une deuxième couche (4) de nitrure dudit métal.

2. Procédé selon la revendication 1, **caractérisé en ce que** l'étape i s'effectue à une température d'au plus 300 °C, de préférence d'au plus 200 °C, et plus préférentiellement d'au plus 100 °C.

3. Procédé selon la revendication 1 ou 2, **caractérisé en ce que** l'étape ii s'effectue à une température d'au plus 300 °C, de préférence d'au plus 200 °C, et plus préférentiellement d'au plus 100 °C.

4. Procédé selon l'une quelconque des revendications précédentes, **caractérisé en ce que** ledit métal est choisi parmi le tantale, le titane et le tungstène, ou un de leurs mélanges.

5. Procédé selon l'une quelconque des revendications précédentes, **caractérisé en ce que** l'espèce oxydante est le trifluorure d'azote (NF₃).

6. Procédé selon l'une quelconque des revendications précédentes, **caractérisé en ce que** le fluorure de métal est le fluorure de tantale ou le fluorure de titane.

7. Procédé selon l'une quelconque des revendications précédentes, **caractérisé en ce que** le plasma d'hydrogène et d'azoté est choisi parmi un mélange d'hydrogène et d'azote ; et un plasma de NH₃ ; ou leur mélange.

8. Diode électroluminescente **caractérisée en ce qu'**elle comprend une première couche (1) de nitrure de metal de transition recouverte par une deuxième couche (4) de nitrure dudit métal, lesdites couches étant obtenues par le procédé de traitement tel que défini aux revendications 1 à 7.

## Patentansprüche

1. Verfahren zur Behandlung einer oxidierten Metallnitridschicht, das die folgenden Schritte umfasst:
i. Oxidieren einer Metalloxidschicht (2) auf der Oberfläche einer ersten Nitridschicht (1) des Metalls mit Hilfe eines Plasmas eines Oxidationsmittels auf Fluorbasis, um eine Metallschicht (3) zu bilden, die aus Fluorid des Metalls zusammengesetzt ist, wobei das Metall der Metallnitridschicht (1), der Metalloxidschicht (2) und der Metallschicht ein Metall ist, das zur Familie der Übergangsmetalle gehört, und
ii. Reduzieren der in Schritt i gebildeten Metallschicht (3) mit Hilfe eines Wasserstoff- und Stickstoffplasmas, um eine zweite Nitridschicht (4) des Metalls zu bilden.

2. Verfahren nach Anspruch 1, **dadurch gekennzeichnet, dass** der Schritt i bei einer Temperatur von höchstens 300 °C, vorzugsweise von höchsten 200 °C und in noch bevorzugter Weise von höchstens 100 °C erfolgt.

3. Verfahren nach Anspruch 1 oder 2, **dadurch gekennzeichnet, dass** der Schritt ii bei einer Temperatur von höchstens 300 °C, vorzugsweise von höchstens 200 °C und in noch bevorzugter Weise von höchstens 100 °C erfolgt.

4. Verfahren nach einem der vorangehenden Ansprüche, **dadurch gekennzeichnet, dass** das Metall aus dem Tantal, dem Titan und dem Wolfram ausgewählt ist oder aus einem ihrer Gemische.

5. Verfahren nach einem der vorangehenden Ansprüche, **dadurch gekennzeichnet, dass** das Oxidationsmittel das Stickstofftrifluorid (NF₃) ist.

6. Verfahren nach einem der vorangehenden Ansprüche, **dadurch gekennzeichnet, dass** das Metallfluorid das Tantalfluorid oder das Titanfluorid ist.

7. Verfahren nach einem der vorangehenden Ansprüche, **dadurch gekennzeichnet, dass** das Wasserstoff- und Stickstoffplasma aus einem Wasserstoff- und Stickstoffgemisch und einem NH₃-Plasma oder ihrem Gemisch ausgewählt ist.

8. Elektrolumineszierende Diode, **dadurch gekennzeichnet, dass** sie eine erste Metallnitridschicht (1) umfasst, die von einer zweiten Nitridschicht(4) des Übergangsmetalls bedeckt ist, wobei die Schichten durch das Behandlungsverfahren hergestellt werden, wie in den Ansprüchen 1 bis 7 definiert.

## Claims

1. A method for treating an oxidized metal nitride layer, comprising the following steps:
i. oxidizing a metal oxide layer (2) on the surface of a first nitride layer (1) of said metal, using a plasma of a fluorine-based oxidizing species, to form a metal layer (3) made up of fluoride of said metal, the metal of the metal nitride layer (1), the metal oxide layer (2) and the metal layer (3) being a metal belonging to the family of transition metals, and
ii. reducing the metal layer (3) formed in step i. using a hydrogen and nitrogen plasma, to form a second nitride layer (4) of said metal.

2. The method according to claim 1, **characterized in that** step i. is carried out at a temperature of no more than 300 °C, preferably no more than 200 °C, and more preferably no more than 100 °C.

3. The method according to claim 1 or 2, **characterized in that** step ii. is carried out at a temperature of no more than 300 °C, preferably no more than 200 °C, and more preferably no more than 100 °C.

4. The method according to any one of the preceding claims, **characterized in that** said metal is chosen from among tantalum, titanium and tungsten, or a mixture thereof.

5. The method according to any one of the preceding claims, **characterized in that** the oxidizing species is nitrogen trifluoride (NF₃).

6. The method according to any one of the preceding claims, **characterized in that** the metal fluoride is tantalum fluoride or titanium fluoride.

7. The method according to any one of the preceding claims, **characterized in that** the hydrogen and nitrogen plasma is chosen from among a mixture of hydrogen and nitrogen; and a NH₃ plasma; or a mixture thereof.

8. A light-emitting diode, **characterized in that** it comprises a first layer (1) of transition metal nitride (2) covered by a second nitride layer (4) of said metal, said layers being obtained using the treatment method as defined in claims 1 to 7.
